# DEMANDE DE BREVET EUROPEEN

(11) **EP 1 276 364 A1**
(43) Date de publication de la demande: **15.01.2003**
(21) Numéro de dépôt: 02291667.0
(22) Date de dépôt: 04.07.2002
(51) Int. Cl.: H05K 9/00

(54) **Tôle multicouche utilisée pour le blindage électromagnetique possédant en outre des propiétés d'isolation thermique et phonique**

(30) Priorité: 12.07.2001 FR 0109270
(71) Demandeur: USINOR, 92800 Puteaux (FR)
(72) Inventeur: Takorabet, Maryse, 54130 Saint Max (FR); Carmet, Alain, 57070 Saint Julien Les Metz (FR)
(74) Mandataire: Plaisant, Sophie Marie (FR)

(57) **Abrégé**

Tôle multicouche utilisée pour le blindage électromagnétique possédant en outre des propriétés d'isolation thermique et phonique améliorées, caractérisée en ce qu'elle se compose de deux parements métalliques ferromagnétiques, entre lesquelles est insérée au moins une âme métallique ferromagnétique présentant une structure polygonale.

## Description

L'invention concerne une tôle multicouche utilisée pour blindage électromagnétique possédant en outre des propriétés d'isolation thermique et phonique améliorées.

Les blindages électromagnétiques sont notamment utilisés pour des lignes enterrées où une pollution électromagnétique nulle est recherchée. Une isolation thermique à haute température, c'est-à-dire jusqu'à 900°C minimum ainsi qu'une isolation phonique sont, de plus, demandées dans les nouvelles conceptions de blindage tubulaire pour les applications dans les lignes électriques enfouies dans le sol.

Dans une fonction de blindage électromagnétique, on cherche à capter au maximum le flux magnétique en atténuant aussi les pertes par échauffement. Ces deux fonctions sont actuellement réalisées à partir d'une simple tôle monolithique.

Le problème de la pollution électromagnétique est un problème de plus en plus soulevé actuellement avec l'émergence d'une électronique de puissance de plus en plus sophistiquée. Les lois européennes et la création de normes à ce sujet et au sujet de l'environnement deviennent fréquentes et de plus en plus contraignantes. On peut citer un projet de directive européenne, JOCE, une Commission Internationale de Protection contre le rayonnement Non lonisants ICNIRP, un Comité européen de Normalisation Electrotechnique CENELEC.

Outre les blindages classiques monolithiques, il existe une demande potentielle pour des blindages de machines électriques, des blindages de salles d'hôpitaux, des blindages pour appareils électroménagers et des blindages de transformateurs de distribution urbaine comme par exemple, les lignes enterrées. Jusqu'alors, une tôle monolithique à forte perméabilité était utilisée.

Des tôles de structures multicouches sont connues dans le domaine du bâtiment ou de l'automobile pour différentes applications mécaniques ou d'allègement. Par exemple, il est connu des tôles multicouches avec notamment de l'aluminium inséré entre deux parements d'acier et utilisées dans le domaine du transport de l'énergie électrique. Elles font appel à des structures géométriques du type nid d'abeilles que l'on peut trouver dans tous les systèmes où une absorption d'énergie est nécessaire. Une telle structure en nid d'abeille réalisée en aluminium ne possède pas de propriété magnétique particulière.

La fonction isolation thermique au niveau d'une ligne électrique enterrée complète n'est actuellement pas assurée. La convection est naturelle au travers des parois et le refroidissement se fait par échange thermique avec le milieu ambiant. Le niveau de température maximal souhaité est de l'ordre de 90°C. Cette élévation de température est produite par des champs électromagnétiques crées par les sources de courants dans les câbles électriques. Elle doit être contrôlée le mieux possible car certains câbles électriques comme par exemple les fils supraconducteurs ne supporteraient pas une marge de température trop importante.

La fonction d'isolation phonique est réalisée de deux manières différentes : une méthode par absorption et une méthode par réflexion.

Dans la méthode par absorption, les volumes à isoler ou insonoriser sont remplis de fibres de basaltes ou de fibres de verre. Ces volumes sont traversés par le composant qui génère le bruit à l'intérieur de ce volume de sorte que les fibres assurent leur rôle d'absorbeur.

Dans la méthode par réflexion, les volumes contiennent un ensemble complexe de chicanes, d'alvéoles ou de formes géométriques qui forment un labyrinthe ou qui servent de réflecteur permettant une atténuation du bruit par réflexion.

Il est connu par exemple du brevet FR 98 15 234 une structure sandwich métallique dont l'âme présente des crevés, structure rigide allégée qui a pour but et pour fonction une isolation thermique et acoustique, dans le domaine de l'électroménager et l'automobile.

Le but de l'invention est de proposer un blindage électromagnétique sous la forme d'une tôle multicouche pour la réalisation de boîtes ou de tubes de blindage électromagnétique.

L'invention a pour objet une tôle multicouche utilisée pour le blindage électromagnétique possédant en outre des propriétés d'isolation thermique et phonique améliorées caractérisée en ce quelle se compose de deux parements métalliques ferromagnétiques, entre lesquelles est insérée au moins une âme métallique ferromagnétique présentant une structure polygonale.

Les autres caractéristiques de l'invention sont :
- l'âme comporte des emboutis générant une nappe d'éléments à géométrie polygonale.
- l'âme comporte des emboutis formant des crevés générant une nappe d'éléments à géométrie polygonale.
- les parements métalliques sont revêtus ou non revêtus.
- au moins un des parements est réalisé à partir d'une tôle en acier de haute perméabilité magnétique ayant de basse perte dans le fer.
- l'âme est réalisée à partir d'au moins une tôle d'acier de haute perméabilité magnétique pouvant être un acier électrique ayant de basse perte dans le fer.
- les parements et l'âme sont composés de tôles d'acier présentant chacune et en combinaison, différentes perméabilités magnétiques.

L'invention concerne également un tube ou volume de blindage réalisé à partir de la tôle multicouche pour blindage et destiné notamment à l'enfouissement des lignes électriques haute tension.

La figure 1 présente des courbes caractéristiques d'induction en fonction de la position de la source pour les tôles, Gmu simple, Gmu poly, Pmu simple, Pmu poly.

La figure 2 présente des courbes de caractéristiques établies dans le domaine thermique.

La figure 3 un schéma en coupe d'une tôle selon l'invention.

Les figures 4a, 4b, 4c présentent un schéma topologique générant, du point de vue magnétique, les familles géométriques, définissant les structures du blindage selon l'invention.

La description qui suit et les figures annexées, le tout donné à titre d'exemple non limitatif, feront bien comprendre l'invention.

L'orientation technique, qui a fait suite à la présentation de l'art antérieur pré cité, a été de développer un produit sidérurgique réalisé à partir d'acier fer-silicium à forte perméabilité, permettant d'atteindre des niveaux de pollution électromagnétiques théoriques nuls. La nouvelle tôle de blindage proposée est plus légère en comparaison des tôles de blindage monolithique.

La tôle de blindage repose sur le mariage technologique des densités de courant de type surfacique et volumique et la circulation du flux magnétique grâce à la perméabilité magnétique existante dans le matériau acier.

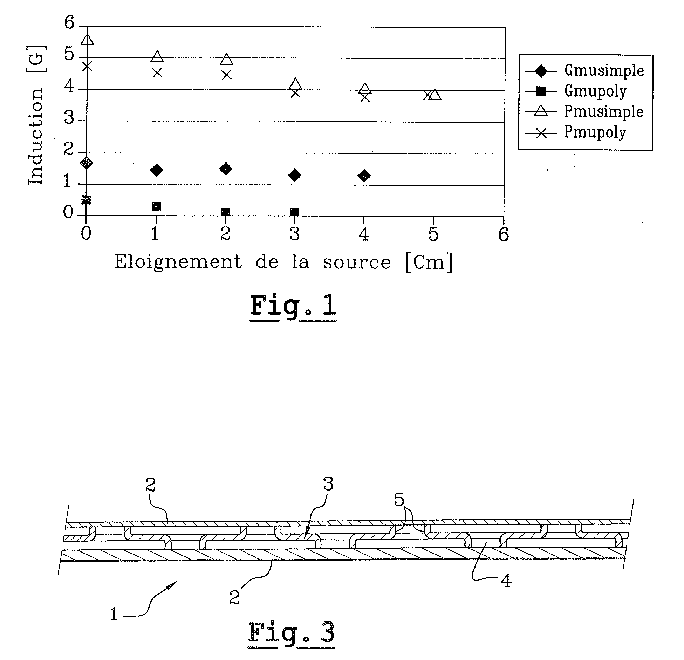

Afin de réaliser la tôle de blindage, il a été construit deux tôles tri couches ; l'une avec une structure usuelle, dénotée par la suite «simple» c'est-à-dire trois tôles monolithiques en forme de sandwich, et l'autre, avec une tôle tri couche dénotée par la suite «poly» c'est-à-dire qu'elle se compose de deux parements métalliques ferromagnétiques, entre lesquelles est insérée au moins une âme métallique ferromagnétique présentant une structure polygonale. Ceci a été effectué sur deux matériaux l'un avec une perméabilité faible, dénoté Pmu pour Petite perméabilité, et l'autre avec une perméabilité forte, dénoté Gmu pour Grande perméabilité. Nous avons effectué des mesures sous plusieurs excitations différentes, notamment en intensité, dans un intervalle d'une dizaine d'ampères à plus de mille ampères et sous différentes fréquences à partir du continu. Il est présenté sur la figure 1 les résultats obtenus sous 400A.

On obtient une chute de l'induction proche de la source de 30% pour les matériaux de faible perméabilité à structure polygonale Pmupoly par rapport au même matériau mais avec une structure simple Pmusimple.

On obtient une chute de l'induction proche de la source de 65% pour les matériaux de forte perméabilité à structure polygonale Gmupoly par rapport au même matériau mais avec une structure simple Gmusimple.

Selon l'invention les parements et l'âme peuvent être composés de tôles d'acier présentant chacune et en combinaison, différentes perméabilités magnétiques, définissant, magnétiquement, trois couches, deux couches extérieures présentant une perméabilité magnétique élevée, la couche intérieure présentant une perméabilité magnétique inférieure à la perméabilité desdites couches extérieures. Pour certaines application, les hauteurs des perméabilités peuvent être inversées.

Des mesures sur des blindages en forme de tubes confirment l'amélioration du blindage électromagnétique lorsque la tôle est mise en forme.

La structure proposée de cette nouvelle tôle permet donc d'améliorer le blindage électromagnétique proche d'une source de courant de 30 à 65% suivant le matériau choisi. Pour atteindre le même niveau de réduction de l'induction, il faudrait rajouter des épaisseurs de tôle dans une tôle de structure simple, ce qui générerait une augmentation de masse non négligeable. La structure de cette nouvelle tôle est donc plus légère qu'une structure simple à niveau de pollution électromagnétique identique. Au travers de ce concept de tôle et de tube, la structure est adaptée, en plus, pour assurer deux fonctions "isolation thermique" et "isolation phonique".

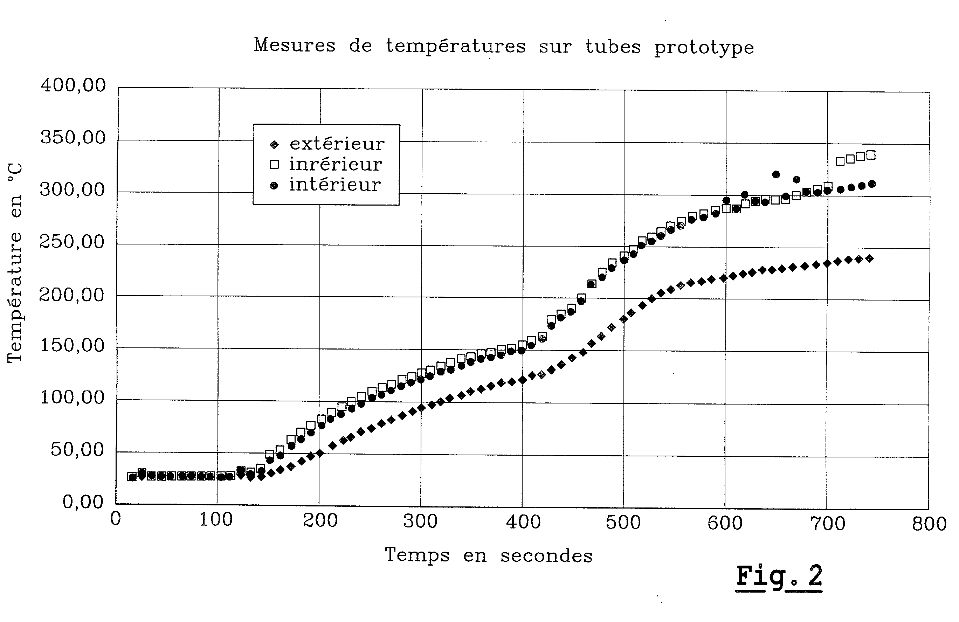

La figure 2 présente des courbes de caractéristiques établies dans le domaine thermique. Nous pouvons remarquer un abaissement de la température de la paroi extérieure d'environ 70°C en comparaison avec la température de la paroi intérieure, abaissement de température lié à l'effet isolant du blindage selon l'invention.

Le blindage selon l'invention, tôle multicouche, est préférentiellement réalisé avec des matériaux à forte perméabilité. Pour les tubes enterrés, l'acier sera choisi revêtu soit électro déposé, soit galvanisé, soit aluminié, soit revêtu de revêtements organiques, soit peint ou encore revêtu par une combinaison de ceux-ci pour une meilleure défense contre la corrosion.

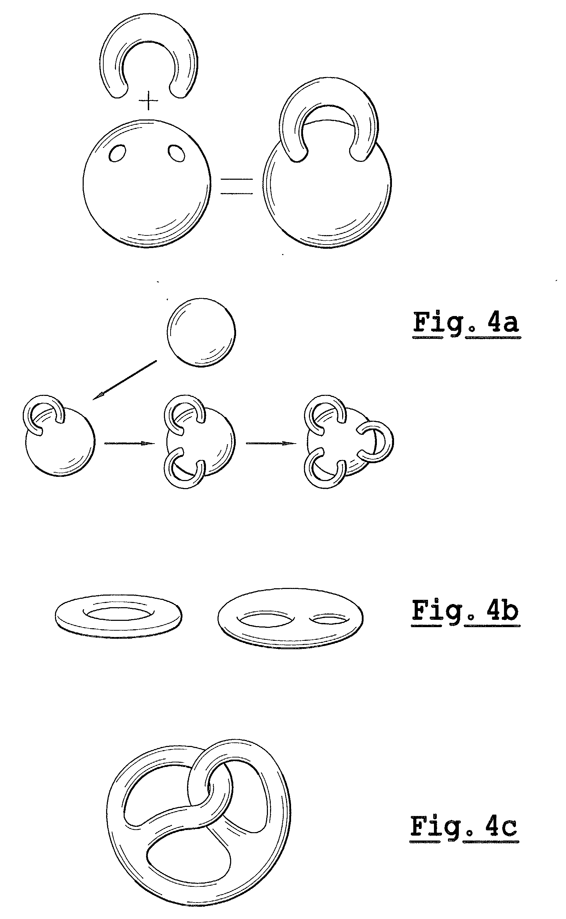

Sur la figure 3, on a représenté schématiquement en coupe transversale une tôle de blindage multicouche selon l'invention. La tôle de blindage 1 se compose, dans cet exemple d'application, de deux parements 2 en acier et d'une âme 3 également en acier. Sur l'âme 3 est aménagé une structure polygonale, qui est définie par la réalisation d'une multitude de trous formant un réseau de maille. Sur la figure; ce réseau est réalisé par la formation d'orifices 4 qui présente, sur tout ou partie de leur périphérie, au moins un bord tombé 5, ici, formant une languette en saillie et venue de matière par la formation de l'orifice en crevé. Il peut être réalisé, sur l'âme 3, un réseau de maille dont les languettes sont réparties en saillies de part et d'autre du plan général de ladite âme.

L'extrémité des languettes est en contact électromagnétique avec les parements 2 pour former des boucles électromagnétiques dans l'épaisseur de la tôle multicouche.

Le problème était de prouver une solution pour stocker de l'énergie dans un système, et dans le cas de l'invention, dans un blindage électromagnétique, sans polluer électromagnétiquement l'extérieur de ce système.

Au niveau topologique et comme schématisé sur les figures 4a, 4b, 4c, le système sphérique génère le plus de familles géométriques dont une que nous retiendrons pour l'exemple d'application. En effet, si l'on découpe sur une sphère deux disques et qu'on y colle une anse (ou plus), on obtient une collection de surfaces bornées distinctes sans bord que l'on appelle surface avec anses. Si deux surfaces ont un nombre différent d'anses, elles sont topologiquement différente : en étirant une sphère avec une anse on obtient un tore, la sphère étirée avec deux anses a le type topologique d'un bretzel. Seul le cas d'une forme torique a été retenu pour une application dans le domaine d'une tôle de blindage.

Ne pas polluer électromagnétiquement l'extérieur d'un domaine blindé revient à rechercher une densité de courant assurant un champ Ho constant.

Dans un tore classique (creux), le champ décroît en 1/r à l'intérieur de la section suivant l'axe radial. Il faut alors une densité de courant supplémentaire qui agisse sur-le-champ de sorte à le rendre constant. D'une manière générale, on cherche, à priori, la densité de courant comme la superposition d'une densité surfacique sur les parois du tore et d'une densité volumique dans le volume du tore.

En prolongeant ce raisonnement, on constate qu'un tore plein est en fait une limite théorique d'un système n-polygonal lorsque n tend vers l'infini. Il est possible d'obtenir une structure de familles de polygones réguliers qui peut donner le jour à des structures d'énergie constante dans une partie des polygones réguliers et dans une partie du domaine, en l'occurrence tout le volume intérieur du polygone, et suivant le polygone choisi, à une énergie plus ou moins grande.

Selon l'invention la structure d'une tôle tricouche basée sur ce principe de pollution électromagnétique nulle et dont nous avons décrit un exemple de réalisation de la figure 3 est considérée comme une structure polygonale à n cotés.

La famille des polygones commence par la forme triangulaire puis la forme carrée ou quadrilatère, puis polygonale.

La tôle de blindage tri couche, comme représenté sur la figure 3, est réalisée à l'aide de deux parements 2 métalliques, de nuances identiques ou légèrement différentes, comme par exemple, des aciers inoxydables, des aciers au carbone revêtus ou non, des aciers en haute perméabilité magnétique et basses pertes dans le fer, au milieu desquels prend place une troisième tôle, âme 3, comportant des orifices 4 munis de languettes 5 formant picots ou crevés.

L'âme peut comporter des ondulations ou gaufrages améliorant les propriétés magnétiques thermiques et phoniques du blindage réalisé. Les languettes réalisées alternativement dans un sens puis dans l'autre, conduisent à une augmentation de l'épaisseur «hors tout» de l'âme comme le montre la figure 3. Elles peuvent varier en forme et en dimension suivant une énergie visée de plus ou moins grande importance et suivent obligatoirement la forme précitée de type n polygonal : la première forme étant le triangle, la deuxième le carré ou le rectangle. L'espace vide, crée par la structure de la tôle de blindage assure la fonction isolation thermique et phonique recherchée.

Les différentes tôles utilisées pour la réalisation de blindage peuvent être de nature et d'épaisseurs différentes.

Le blindage peut avoir la forme d'un tube, les parements et l'âme sont de préférence maintenus entre elles par points soudés, clinchage, agrafes, sertissage, soudage, soudage molette ou laser ou par adhésif. Cependant d'autres volumes comme des armoires, pièces, boîtes peuvent être réalisées à partir d'assemblage continu ou discontinu suivant les procédés de soudage électrique, par exemple, soudo brasage, soudage à la flamme. Le choix de l'assemblage se fera en fonction de l'utilisation du produit envisagée.

Au lieu d'utiliser une forme de boule pour l'embouti comme pour une tôle gaufrée, on crée dans l'âme, des formes polygonales, triangulaires, carrées ou n polygonales, puis on accole par les procédés précités les deux tôles de parements. Cette solution peut permettre des réductions de coûts liés :
- au choix des matériaux utilisés,
- aux économies de produits ou matériaux ou solutions choisies initialement pour répondre aux impératifs de blindage électromagnétique et d'isolation thermique et phonique.

La mise en oeuvre du blindage peut se faire sur des outils traditionnellement utilisés pour de simples tôles monolithiques.

Il est possible de réaliser une pièce tubulaire mise en forme par roulage.

Un tube de blindage, selon l'invention mis en forme par roulage, a été réalisé et les performances d'amortissement acoustique ont été mises en évidence.

Des mesures de températures à l'intérieur et à l'extérieur de ce même tube de blindage traversé par de l'air chauffé à 350°C ont montré en statique, c'est-à-dire sans écoulement d'air, que la paroi extérieure ne s'élevait qu'à une température de 240°C.

En résumé, cette invention trouve son application dans les différents cas d'application où une pollution électromagnétique minimale est demandée, avec de plus, des qualités phoniques et thermiques.

## Revendications

1. Tôle multicouche utilisée pour le blindage électromagnétique possédant en outre des propriétés d'isolation thermique et phonique améliorées, **caractérisée en ce qu'**elle se compose de deux parements métalliques ferromagnétiques, entre lesquelles est insérée au moins une âme métallique ferromagnétique présentant une structure polygonale.

2. Tôle de blindage selon la revendication 1, **caractérisée en ce que** l'âme comporte des emboutis générant une nappe d'éléments à géométrie polygonale.

3. Tôle de blindage selon la revendication 1, **caractérisée en ce que** l'âme comporte des emboutis formant des crevés générant une nappe d'éléments à géométrie polygonale.

4. Tôle de blindage selon la revendication 1, **caractérisée en ce que** les parements métalliques sont revêtus ou non revêtus.

5. Tôle de blindage selon la revendication 1, **caractérisée en ce qu'**au moins un des parements est réalisé à partir d'une tôle en acier de haute perméabilité magnétique ayant de basse perte dans le fer.

6. Tôle de blindage selon la revendication 1, **caractérisée en ce que** l'âme est réalisée à partir d'au moins une tôle d'acier de haute perméabilité magnétique pouvant être un acier électrique ayant de basse perte dans le fer.

7. Tôle de blindage selon la revendication 1, **caractérisée en ce que** les parements et l'âme sont composés de tôles d'acier présentant chacune et en combinaison, différentes perméabilités magnétiques.

8. Tube ou volume de blindage réalisé à partir de la tôle multicouche pour blindage selon les revendications 1 à 7 et destiné notamment à l'enfouissement des lignes électriques haute tension.
